Europäisches Patentamt

European Patent Office

Office européen des brevets

(19)

(11) **EP 1 152 425 A2**

(12) **EUROPÄISCHE PATENTANMELDUNG**

(43) Veröffentlichungstag:
    **07.11.2001 Patentblatt 2001/45**

(51) Int Cl.⁷: **G11C 5/00**

(21) Anmeldenummer: **01109864.7**

(22) Anmeldetag: **23.04.2001**

(84) Benannte Vertragsstaaten:
    **AT BE CH CY DE DK ES FI FR GB GR IE IT LI LU MC NL PT SE TR**
    Benannte Erstreckungsstaaten:
    **AL LT LV MK RO SI**

(30) Priorität: **02.05.2000 DE 10021371**

(71) Anmelder: **Infineon Technologies AG**
    **81669 München (DE)**

(72) Erfinder: **Schaefer, Andre**
    **80637 München (DE)**

(74) Vertreter: **MÜLLER & HOFFMANN Patentanwälte**
    **Innere Wiener Strasse 17**
    **81667 München (DE)**

(54) **Speichereinrichtung**

(57) Bei einer Schaltungsanordnung, insbesondere einem DRAM-Element, mit einer Schutzeinrichtung (4) zum Unterbinden des Ausbildens und/oder Ausgebens eines auf einem empfangenen zugeführten Eingangssignal (I) beruhenden Reflexionssignals (R) wird vorgeschlagen, eine aktive Signalanpaßeinrichtung (5) vorzusehen, durch welche durch Verbrauch des Eingangssignals die Ausbildung eines Reflexionssignals verhinderbar ist.

Fig. 1

EP 1 152 425 A2

**Beschreibung**

Die Erfindung betrifft eine Schaltungsanordnung gemäß dem Oberbegriff des Anspruchs 1.

Bei vielen elektrischen Systemen und Schaltungsanordnungen werden bestimmte Signale von Teilen des Systems, z.B. sogenannten Treibern, ausgesandt und an andere Teile des Systems, sogenannte Empfänger oder Receiver, bereitgestellt und übertragen. Problematisch bei elektrischen Systemen, Schaltungsanordnungen, z.B. Speichereinrichtungen, insbesondere DRAM-Elementen, ist dabei, daß in vielen Fällen - insbesondere wenn die Eingangsimpedanz hochohmig und hauptsächlich kapazitiv ausgelegt ist - aufgrund des Wellenwiderstandes des Eingangsbereichs eines derartigen elektrischen Systems oder einer Schaltungsanordnung eine im Eingangsbereich dieses Systems oder der Schaltungsanordnung eintreffende Signalflanke oder Spannungsflanke zumindest teilweise, oft jedoch totalreflektiert wird. Das reflektierte Signal oder Reflexionssignal läuft dann aus dem Eingangsbereich der empfangenden Schaltungsanordnung aus und auf die sendende Einheit hin zurück. Das Reflexionssignal kann dann dort und/oder darüber hinaus zu einer Fehlfunktion und somit insgesamt zu einer gesamten Fehlfunktion des elektrischen Systems führen.

Bei bekannten Schaltungsanordnungen, gerade auch bei Speichereinrichtungen, insbesondere bei DRAM-Elementen, wurden daher vielfältige Maßnahmen vorgeschlagen, um das Ausbilden und/ oder das Aussenden von auf Eingangssignalen beruhenden Reflexionssignalen zu unterbinden.

Es wurden z.B. Schutzeinrichtungen vorgeschlagen, die an den spezifischen Eingangs-/Wellenwiderstand des Eingangsbereichs der Schaltungsanordnung angepaßt sind und im Hinblick auf den konkreten Wellenwiderstand des Eingangsbereichs zumindest zu einer teilweisen Unterdrückung eines Reflexionssignales führen.

Bekannte derartige Schutzeinrichtungen in Schaltungsanordnungen sehen z.B. Vorwiderstände zum Dämpfen des rücklaufenden Reflexionssignals vor. Dadurch werden zum einen die einlaufende Welle und zum anderen nach Reflexion auch die auslaufende Welle und somit die zurücktransportierte Leistung gedämpft.

Eine andere bekannte Maßnahme zum Schutz vor Reflexionssignalen ist das Vorsehen eines konzentrierten Widerstands in Parallelschaltung im Eingangsbereich der Schaltungsanordnung, wobei der Wert des Widerstands passend zum Wellenwiderstand gewählt wird, wobei eine starke Unterdrückung des Ausbildens und Aussendens eines Reflexionssignals erreicht werden kann.

Nachteilig bei diesen bekannten Schaltungsanordnungen und den darin vorgesehenen Schutzeinrichtungen ist, daß diese jeweilige Schutzeinrichtung zum teilweisen Unterbinden des Ausbildens und/oder Aussendens von Reflexionssignalen immer auf den spezifischen Wert des im Eingangsbereich der Schaltungsanordnung vorliegenden Wellenwiderstandes abgestimmt ist. Dabei ist es insbesondere nachteilig, daß bei einer Änderung dieses Wellenwiderstandes die entsprechende Schutzeinrichtung auf die veränderten Bedingungen nicht mehr eingestellt und der Schutz nicht mehr ausreichend gewährleistet werden kann. Derartige Änderungen des Wellenwiderstands im Eingangsbereich bekannter Schaltungsanordnungen ergeben sich z.B. im Zusammenhang mit Variationen im Rahmen des Produktionsprozesses der Schaltungsanordnung aber auch durch Wechselwirkung mit der Schaltungsanordnung nachfolgenden elektrischen Systemen.

Der Erfindung liegt die Aufgabe zugrunde, eine Schaltungsanordnung, z.B. eine Speichereinrichtung, insbesondere ein DRAM-Element, oder dergleichen zu schaffen, bei welchem das Ausbilden und/oder Aussenden eines auf empfangenen zugeführten Eingangssignalen beruhenden Reflexionssignales auf besonders einfache aber gleichwohl zuverlässige und flexible Art und Weise unterdrückt werden kann.

Die Aufgabe wird erfindungsgemäß mit einer gattungsgemäßen Schaltungsanordnung durch die kennzeichnenden Merkmale des Anspruchs 1 gelöst. Vorteilhafte Weiterbildungen der erfindungsgemäßen Schaltungsanordnung sind Gegenstand der abhängigen Unteransprüche.

Bei der gattungsgemäßen Schaltungsanordnung, z.B. Speichereinrichtung, insbesondere DRAM-Element, oder dergleichen ist mindestens ein Eingangsbereich vorgesehen, welcher zumindest zum Empfang eines zugeführten elektrischen Eingangssignals ausgebildet ist und welcher dazu mindestens eine Eingangsleitungseinrichtung aufweist. Ferner ist eine Schutzeinrichtung vorgesehen, welche am Eingangsbereich ausgebildet ist und welche zumindest zum teilweisen Unterbinden des Ausbildens und/oder Ausgebens eines auf einem empfangenen zugeführten Eingangssignal beruhenden Reflexionssignals, insbesondere auf der Eingangsleitungseinrichtung, ausgebildet ist.

Die erfindungsgemäße Schaltungsanordnung ist dadurch gekennzeichnet, daß die Schutzeinrichtung eine aktive Kompensationseinrichtung aufweist, durch welche ein Kompensationssignal generierbar und/oder einem sich ausbildenden und/oder ausgesandt werdenden Reflexionssignal überlagerbar ist.

Eine Grundidee der vorliegenden Erfindung besteht also darin, anstelle einer passiven Reflexionsunterdrückung ein entstehendes Reflexionssignal und/ oder das Aussenden eines bereits entstandenen Reflexionssignals durch geeignete Superposition, d.h. insbesondere durch destruktive Interferenz, mit einem Kompensationssignal zumindest teilweise zu kompensieren. Während bei passiven und fest gewählten Schutzmaßnahmen, z.B. bei festen Vorwiderständen oder konstanten konzentrierten Parallelwiderständen, eine Anpassung an sich ändernde Rahmenbedingungen aufgrund der festen Wahl der Bauteile nicht möglich ist, bietet der erfindungsgemäße Einsatz eines aktiv generierten Kompensationssignals eine größtmögliche Flexibilität bei der Unterdrückung von Reflexionen, auch dann, wenn sich aufgrund variierender Produktionsbedingungen und/oder aufgrund weiterer wechselwirkender Schaltungsanordnungen im Nachgang zum Eingangsbereich der apparente Wellenwiderstand und somit das Reflexionsverhalten im Eingangsbereich ändern.

Die Grundidee der vorliegenden Erfindung kann auch dahingehend aufgefaßt werden, daß anstelle einer passiven Reflexionsunterdrückung eine aktive Signalanpassung durchgeführt wird, wobei durch Verbrauch des Eingangssignals die Ausbildung eines Reflexionssignals verhindert oder unterdrückt wird. Dies wird erfindungsgemäß dadurch erreicht, daß eine aktive Signalanpaßeinrichtung vorgesehen ist, welche gerade den Verbrauch des Eingangssignals und somit die Unterdrückung oder Verhinderung der Ausbildung eines Reflexionssignals realisiert.

Nachfolgend soll unter der aktiven Kompensationseinrichtung, durch welche ein Kompensationssignal generierbar und einem sich ausbildenden Reflexionssignal überlagerbar ist, auch immer eine aktive Signalanpaßeinrichtung verstanden werden, welche durch Verbrauch des Eingangssignals die Ausbildung eines Reflexionssignals verhindert.

Dabei ist es von besonderem Vorteil, wenn die Kompensationseinrichtung steuerbar ausgebildet ist, insbesondere im Rahmen eines Rückkopplungssteuerkreises. Mit dieser Maßnahme kann z.B. erreicht werden, daß über eine entsprechende Sensorik das tatsächliche Ausbilden und/oder Aussenden eines Reflexionssignals permanent und zu gegebenen Zeitpunkten überwacht wird, um dann beim Vorliegen eines bestimmten Schwellenwertes im Reflexionssignal eine entsprechende Anpassung des Kompensationssignals sowohl zeitlich als auch amplitudenmäßig - ggf. instantan - vorzunehmen.

Dazu ist es vorteilhaft, wenn zur Steuerung der Kompensationseinrichtung eine entsprechende Steuereinrichtung, insbesondere im Eingangsbereich der Schaltungsanordnung, vorgesehen ist.

Zur Ausführung der Steuerung der Kompensationseinrichtung wird in einer bevorzugten Ausführungsform der erfindungsgemäßen Schaltungsanordnung mindestens eine Regelgröße, insbesondere eine Spannung und/oder ein Strom, insbesondere von der Eingangsleitungseinrichtung, auf welcher die Reflexionswelle oder das Reflexionssignal zur ursprünglich sendenden Einheit zurücklaufen würde, der Kompensationseinrichtung und/oder der Steuereinrichtung zugeführt.

Zur Ausbildung des Kompensationssignals ist in einer weiteren Ausführungsform der erfindungsgemäßen Schaltungsanordnung mindestens eine, insbesondere steuerbare, Stromquelleneinrichtung vorgesehen, die auch als Stromquellenverstärkungseinrichtung aufgefaßt werden kann. Auf ein Steuersignal hin wird somit in der Stromquelleneinrichtung ein entsprechendes Stromsignal zur Überlagerung mit einem sich ausbildenden Reflexionssignal generiert und insbesondere der Eingangsleitungseinrichtung bereitgestellt.

Dabei ist es von besonderem Vorteil, wenn die Stromquelleneinrichtung zu einer Stromgenerierung und/oder -verstärkung ausgebildet ist, welche einem gegebenen Wellenwiderstand, insbesondere des Eingangsbereichs der Schaltungsanordnung, angepaßt ist und welche insbesondere die Beziehung

$$1/g_m = Z_1 = U_{rec}/I_{source}$$

erfüllt, wobei $U_{rec}$ die empfangene elektrische Spannung am Eingangsbereich, $I_{source}$ der empfangene elektrische Strom im Eingangsbereich, $Z_l$ der Eingangswellenwiderstand des Eingangsbereichs und $g_m$ die Stromverstärkung bedeuten. Dadurch wird erreicht, daß das generierte und bereitgestellte Stromsignal der Stromquelleneinrichtung gerade an den aktuellen Wellenwiderstand des Eingangsbereichs angepaßt ist, so daß ein sich ausbildendes Reflexionssignal besonders effektiv unterdrückt werden kann. Mit einer fest verdrahteten und fixen herkömmlichen Schutzeinrichtung wäre eine derartig flexible Anpassung der Unterdrückung an einen sich ändernden Wellenwiderstand im Eingangsbereich der Schaltungsanordnung nicht realisierbar. Dies stellt einen besonderen Vorteil des erfindungsgemäßen Vorgehens dar.

Zur besonders effektiven Ausführung des Unterdrückens und/ oder Unterbindens eines Reflexionssignals ist es bei der erfindungsgemäßen Schaltungsanordnung gemäß einer weiteren vorteilhaften Ausführungsform vorgesehen, daß die Steuereinrichtung eine Vergleichseinrichtung aufweist, welche zum Vergleichen einer zugeführten Regelgröße mit einer vorgegebenen Führungsgröße oder Sollgröße und zum Generieren und Bereitstellen eines Vergleichssignals und/oder Steuersignals, insbesondere an die Kompensationseinrichtung, ausgebildet ist.

Bei der zugeführten Regelgröße kann es sich dabei insbesondere um einen im Eingangsbereich und insbesondere in der Eingangsleitungseinrichtung gemessenen Wert des dort vorliegenden aktuellen elektrischen Stroms oder einer elektrischen Spannung handeln. Die Führungsgröße entspräche dabei einem Sollwert oder Schwellenwert für die elektrische Spannung oder den elektrischen Strom, welcher im Eingangsbereich durch die Reflexionswelle nicht überschritten werden darf.

Durch den auszuführenden Vergleich wird in der Vergleichseinrichtung festgestellt, ob die entsprechenden Schwellenwerte überschritten werden. Als Reaktion auf ein Überschreiten wird aktuell und instantan ein entsprechendes Vergleichssignal und/oder Steuersignal generiert und insbesondere an die Kompensationseinrichtung ausgegeben, wodurch ebenfalls instantan eine entsprechende Kompensation des Reflexionssignals erfolgt.

Eine besonders vorteilhafte Ausbildung der erfindungsgemäßen Schaltungsanordnung ergibt sich, wenn die Kompensationseinrichtung eine Mehrzahl von Stromquelleneinrichtungen aufweist, die Steuereinrichtung eine Registereinrichtung aufweist und die Registereinrichtung zum Auswählen und/oder Bestimmen der aktiven und/oder der zu aktivierenden Stromquelleneinrichtungen und/oder der jeweiligen Stromverstärkungen ausgebildet ist.

Durch die vorgesehene Mehrzahl von Stromquelleneinrichtungen ist eine besonders einfache, flexible und schnelle Anpassung des Kompensationssignals an das sich ausbildende Reflexions-signal möglich. Dabei können über die Registereinrichtung die jeweils aktiven und/oder zu aktivierenden Stromquelleneinrichtungen ausgewählt werden. Es ist somit möglich, mehrere, gegebenenfalls auch identische, Stromquellen in der Kompensationseinrichtung, z.B. über entsprechende Schalter, vorzusehen. Je nach Stärke des sich ausbildenden Reflexionssignals werden dann eine oder mehrere dieser Stromquellen, welche parallel geschaltet sind, aktiviert, so daß jede einzelne Stromquelle ihren einzelnen Beitrag zum Aufbau und zur Überlagerung des Kompensationssignals mit dem Reflexionssignal generiert und bereitstellt. Andererseits oder zusätzlich kann daran gedacht werden, daß durch die Registereinrichtung auch die entsprechenden Verstärkungsfaktoren der einzelnen Stromquellen gesteuert werden, z.B. über eine entsprechende zuzuführende Gate-/Basis-Spannung, falls die jeweiligen Stromquellen z. b. als Bipolar- oder Feldeffekttransistoren ausgebildet sind.

Eine weitere Steigerung der Flexibilität und Zuverlässigkeit der Kompensation von Reflexionssignalen ergibt sich, wenn die Vergleichseinrichtung und/oder die Registereinrichtung, insbesondere extern, programmierbar ausgebildet sind. Dadurch können nämlich die Schwellenwerte, welche beim Überschreiten zu einer Nachregelung des Kompensationsverhaltens und des Kompensationssignals führen, angepaßt werden. Ferner kann eine programmierbare Registereinrichtung auch dazu genutzt werden, das Verhalten der Kompensationseinrichtung auch im Nachhinein anzupassen und zu optimieren.

Nachfolgend wird die Erfindung anhand einer schematischen Zeichnung auf der Grundlage bevorzugter Ausführungsbeispiele der erfindungsgemäßen Schaltungsanordnung weiter erläutert. In dieser zeigt

Fig. 1    in Form eines Blockdiagramms ein erstes Ausführungsbeispiel der erfindungsgemäßen Schaltungsanordnung,

Fig. 2    in Form eines Blockdiagramms ein zweites Ausführungsbeispiel der erfindungsgemäßen Schaltungsanordnung,

Fig. 3    in Form eines Blockdiagramms eine Kompensationseinrichtung in einem dritten Ausführungsbeispiel der erfindungsgemäßen Schaltungsanordnung und

Fig. 4    in Form eines Blockdiagramms eine Schaltungsanordnung aus dem Stand der Technik.

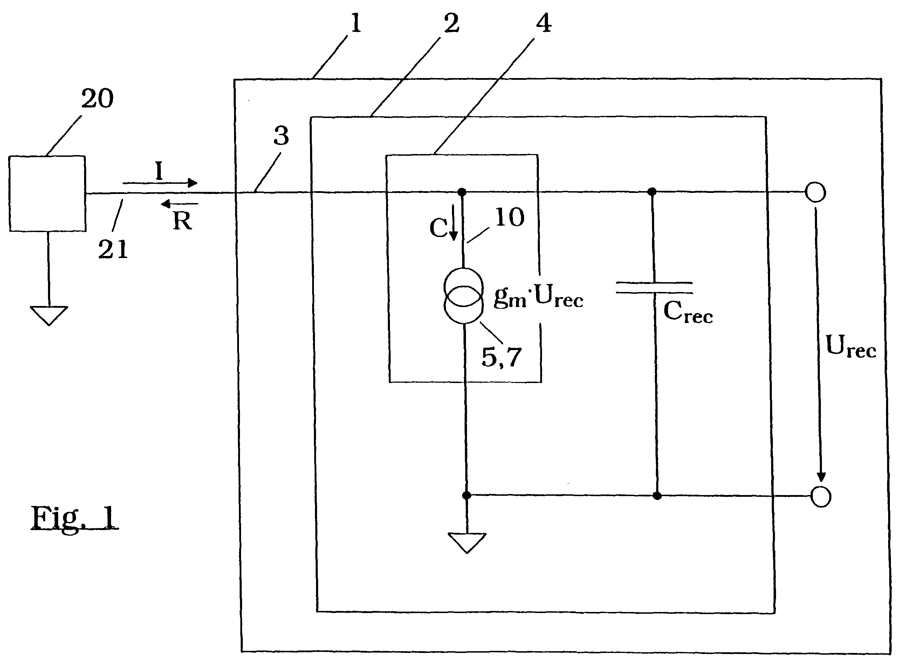

In dem in Fig. 1 in Form eines Blockdiagramms dargestellten ersten Ausführungsbeispiel der erfindungsgemäßen Schaltungsanordnung 1 ist der Eingangsbereich 2 der Schaltungsanordnung über eine Eingangsleitungseinrichtung 3 mit einer externen sendenden Einrichtung 20 und deren Ausgangsleitungseinrichtung 21 verbunden, über welche ein Eingangssignal I an die erfindungsgemäße Schaltungsanordnung 1 übertragen wird. Im hier hochohmigen Eingangsbereich 2 der Schaltungsanordnung 1 bildet sich dann aufgrund der Fehlanpassung der Eingangskapazität $C_{rec}$ an die gegebene Wellenimpedanz $Z_1$ ein rücklaufendes Reflexionssignal R aus, welches über die Eingangsleitungseinrichtung 3 zur Ausgangsleitungseinrichtung 21 der sendenden Einheit 20 zurückläuft.

Im Eingangsbereich 2 der Schaltungsanordnung 1 ist eine Schutzeinrichtung 4 vorgesehen, welche über eine Kompensationsleitung 10 ein von einer als Kompensationseinrichtung 5 dienenden gesteuerten Stromquelleneinrichtung 7 generiertes Kompensationssignal C an die Eingangsleitungseinrichtung 3 zur Kompensation des sich ausbildenden Reflexionssignals R bereitstellt. Der durch den Pfeil C gegenüber den Pfeil I verkürzte Pfeil R mag diese teilweise Kompensation andeuten.

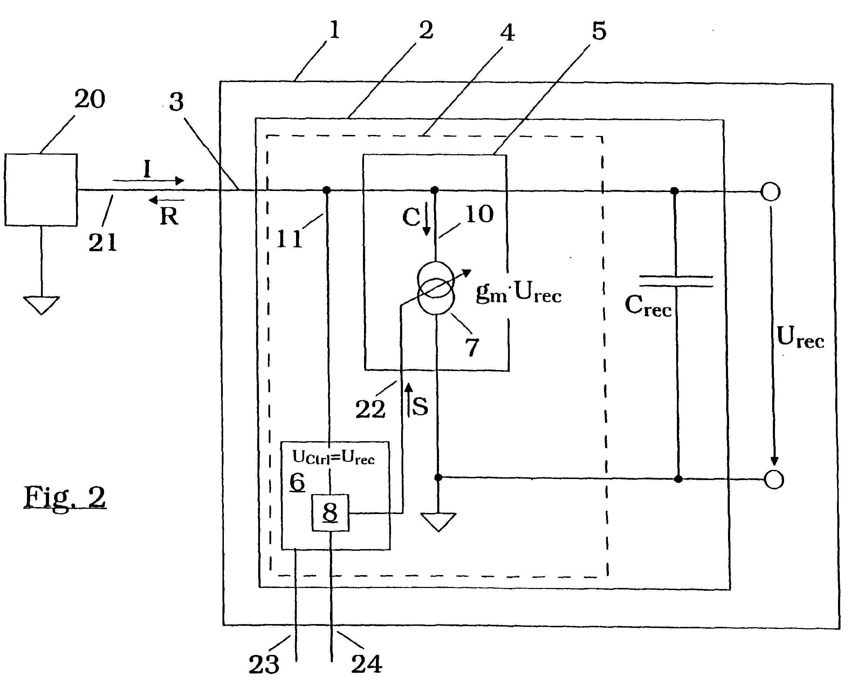

In der Fig. 2 ist ein zweites Ausführungsbeispiel der erfindungsgemäßen Schaltungsanordnung 1 ebenfalls in Form eines Blockdiagramms gezeigt.

Die Schaltungsanordnung 1 empfängt in ihrem Eingangsbereich 2 auf der Eingangsleitungseinrichtung 3, welche wieder mit der Ausgangsleitungseinrichtung 21 einer extern sendenden Einheit 20 verbunden ist, wiederum ein Eingangssignal I, welche zur Ausbildung eines teilkompensierten Reflexionssignals R führt.

Im Eingangsbereich 2 der Schaltungsanordnung 1 ist eine Schutzeinrichtung 4 mit einer Kompensationseinrichtung 5 ausgebildet, wobei letztere über eine Kompensationsleitung 10 ein generiertes Kompensationssignal C in die Eingangsleitungseinrichtung 3 des Eingangsbereichs 2 einspeist. Die Kompensationseinrichtung 5 weist zur Generierung und Bereitstellung des Kompensationssignals C eine steuerbare Stromquelleneinrichtung 7 oder Stromquellenverstärkungseinrichtung auf. Diese Stromquelleneinrichtung 7 oder Stromquellenverstärkungseinrichtung wird über die Steuereinrichtung 6 mittels einer Steuerleitung 22 mit einem Steuersignal S beaufschlagt.

In dem in Fig. 2 gezeigten Ausführungsbeispiel wird das Steuersignal S in der Steuereinrichtung 6 durch Abtasten des Reflexionssignals R auf der Eingangsleitungseinrichtung 3 mittels der Abtastleitung 11 und der Vergleichseinrichtung 8 in der Steuereinrichtung 6 erzeugt und realisiert.

Die Steuereinrichtung 6 und/oder die Vergleichseinrichtung 8 können über externe Steuerleitungen 23 bzw. 24 - insbesondere extern programmierbar - steuerbar sein.

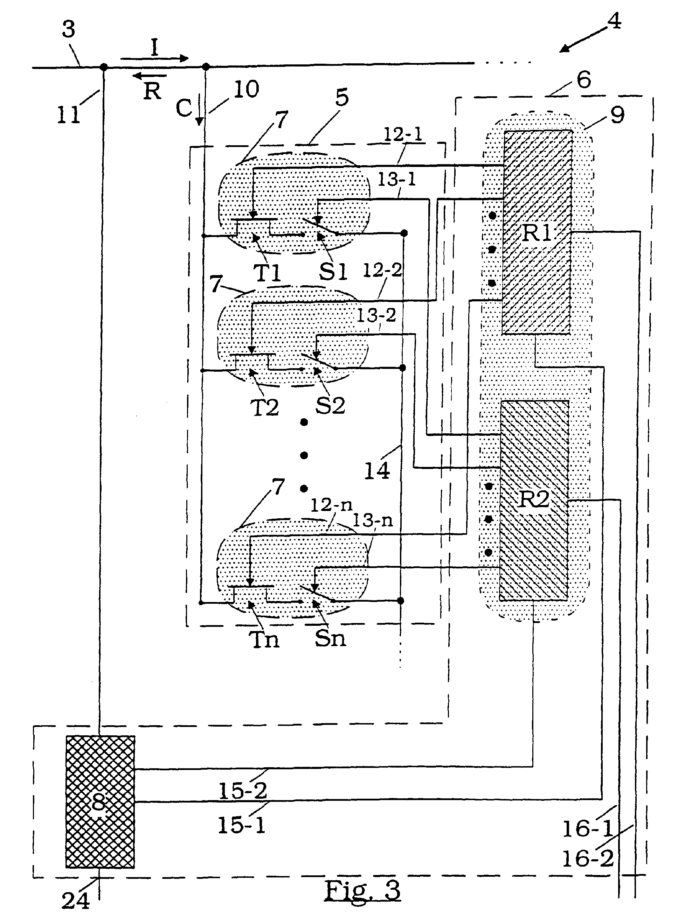

Fig. 3 zeigt in einem weiteren Blockdiagramm eine Detailansicht einer weiteren Ausführungsform der erfindungsgemäßen Schaltungsanordnung 1, und zwar im Hinblick auf die Schutzeinrichtung 4.

Bei diesem Ausführungsbeispiel sind n voneinander unabhängige Stromquelleneinrichtungen 7 vorgesehen. Diese werden über eine gemeinsame Versorgungsleitung 14 versorgt und über voneinander getrennte und unabhängige Stromsteuerleitungen 12-1, ..., 12-n und ebenso voneinander getrennte und voneinander unabhängige Schaltleitungen 13-1, ..., 13-n bezüglich der zu erzeugenden Stromstärke bzw. bezüglich ihres Einschaltzustandes gesteuert.

Dazu sind in jeder der Stromquelleneinrichtungen 7 jeweils ein Transistor T1, ..., Tn zur Stromsteuerung vorgesehen, wobei die jeweiligen Stromsteuerleitungen 12-1, ..., 12-n als Basisleitungen fungieren. Der Schaltzustand wird jeweils über Schaltelemente S1, ..., Sn, welche ebenfalls als Transistoren ausgelegt sein können und welche mit den Transistoren T1, ..., Tn jeweils in Serie geschaltet sind, geregelt.

Anstelle der Transistoren T1, ..., Tn können ganz allgemeine, insbesondere gesteuerte, Stromquelleneinrichtungen vorgesehen sein. In Fig. 3 wären dann die entsprechenden Trabnsistorsymbole durch Symbole für eine allgemeine Stromquelle zu ersetzen.

Die jeweiligen Beiträge der einzelnen Stromquelleneinrichtungen 7 erfolgen durch Parallelschaltung über die Kompensationsleitung 10 in der Schutzeinrichtung 4.

Es ist eine Registereinrichtung 9 vorgesehen, welche ein erstes Register R1 und ein zweites Register R2 aufweist, die zur Steuerung der Stromstärken der Stromquelleneinrichtungen 7 über die Stromsteuerleitungen 12-1, ..., 12-n bzw. zur Steuerung des Einschaltzustandes der Stromquelleneinrichtungen 7 über die Schaltleitungen 13-1, ..., 13-n vorgesehen sind.

Die Register R1 und R2 der Registereinrichtung 9 sind in der Steuereinrichtung 6 angeordnet und werden über Busleitungen 15-1, 15-2 und 16-1, 16-2 mit der Vergleichseinrichtung 8, mit anderen Schaltungseinrichtungen bzw. mit der Außenwelt steuerbar verbunden.

Die Vergleichseinrichtung 8 ihrerseits empfängt über die Abtastleitung 11 als Regelgröße den Strom und/oder die Spannung des Reflexionssignals R auf der Eingangsleitungseinrichtung 3 des Eingangsbereichs 2 und führt dann eine entsprechende Vergleichsoperation mit einer vorgegebenen Führungs- oder Sollgröße, welche gegebenenfalls über eine externe Steuerleitung 24 bereitgestellt oder verändert werden kann, durch.

Die Registereinrichtung 9 mit ihren Registern R1, R2 kann als sogenanntes Modusregister dienen und - insbesondere extern - programmierbar sein.

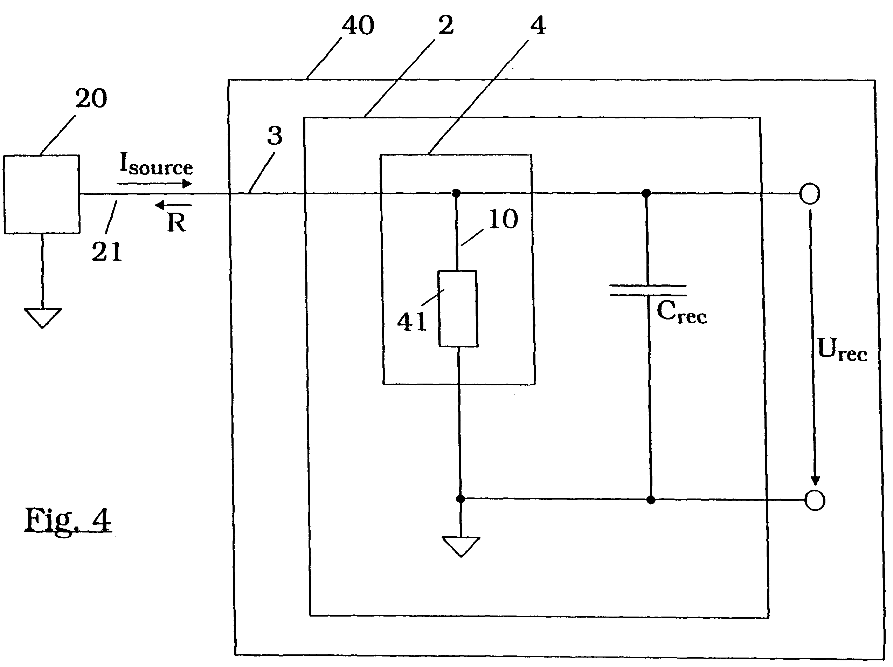

Fig. 4 zeigt ebenfalls in Form eines Blockdiagramms eine Schaltungsanordnung 40 aus dem Stand der Technik, wobei im Eingangsbereich 2 der Schaltungsanordnung 40 eine Schutzeinrichtung 4 vorgesehen ist, welche hier ausschließlich aus einem passiven parallel geschalteten konzentrierten Widerstand 41 besteht, welcher im Zusammenhang mit der Eingangskapazität $C_{rec}$ des Eingangsbereichs 2 so gewählt ist, daß sich das aufgrund des über die Eingangsleitungseinrichtung 3 empfangenen Eingangssignals $I_{source}$ ausbildende Reflexionssignal R bei gegebenem und festem Wellenwiderstand $Z_1 = U_{rec}/I_{source}$ bestmöglich unterdrücken läßt.

**Patentansprüche**

1. Schaltungsanordnung, z.B. Speichereinrichtung, insbesondere DRAM-Element, oder dergleichen, mit:

   - mindestens einem Eingangsbereich (2), welcher zumindest zum Empfang eines zugeführten elektrischen Eingangssignals (I) ausgebildet ist und welcher dazu mindestens eine Eingangsleitungseinrichtung (3) aufweist, und
   - einer Schutzeinrichtung (4), welche im Eingangsbereich (2) vorgesehen ist und welche zumindest zum teilweisen Unterbinden des Ausbildens und/oder Ausgebens eines auf einem empfangenen zugeführten Eingangssignal (I) beruhenden Reflexionssignals (R) - insbesondere auf die Eingangsleitungseinrichtung (3) - ausgebildet ist,

   **dadurch gekennzeichnet,**
   **daß** die Schutzeinrichtung (4) eine aktive Kompensationseinrichtung (5) aufweist, durch welche ein Kompensationssignal (C) generierbar ist und/oder einem sich ausbildenden und/oder ausgesandt werdenden Reflexionssignal (R) überlagerbar ist.

2. Schaltungsanordnung nach Anspruch 1,
   **dadurch gekennzeichnet,**
   **daß** die Kompensationseinrichtung (5), insbesondere rückgekoppelt, steuerbar ausgebildet ist.

3. Schaltungsanordnung nach einem der Ansprüche 1 oder 2,
   **dadurch gekennzeichnet,**
   **daß** zur Steuerung der Kompensationseinrichtung (5) eine Steuereinrichtung (6) vorgesehen ist.

**4.** Schaltungsanordnung nach einem der vorangehenden Ansprüche,
**dadurch gekennzeichnet,**
**daß** zur Steuerung der Kompensationseinrichtung (5) mindestens eine Regelgröße, insbesondere eine Spannung und/oder ein Strom, insbesondere von der Eingangsleitungseinrichtung (3), der Kompensationseinrichtung (5) und/oder der Steuereinrichtung (6) zuführbar ist.

**5.** Schaltungsanordnung nach einem der vorangehenden Ansprüche,
**dadurch gekennzeichnet,**
**daß** die Kompensationseinrichtung (5) mindestens eine, insbesondere steuerbare, Stromquelleneinrichtung (7) aufweist.

**6.** Schaltungsanordnung nach Anspruch 5,
**dadurch gekennzeichnet,**
**daß** die Stromquelleneinrichtung (7) zum Generieren und/oder Bereitstellen eines elektrischen Stromsignales, insbesondere an die Eingangsleitungseinrichtung (3), ausgebildet ist.

**7.** Schaltungsanordnung nach einem der Ansprüche 5 oder 6,
**dadurch gekennzeichnet,**
**daß** die Stromquelleneinrichtung (7) zu einer Stromgenerierung und/oder -verstärkung ($g_m$) ausgebildet ist, welche einem gegebenen Wellenwiderstand ($Z_1$), insbesondere des Eingangsbereichs (2), entspricht und welche insbesondere die Beziehung

$$1/g_m = Z_1 = U_{rec}/I_{source}$$

erfüllt, wobei $U_{rec}$ die empfangene elektrische Spannung am Eingangsbereich (2), $I_{source}$ der empfangene elektrische Strom im Eingangsbereich (2), $Z_1$ des Eingangswellenwiderstand im Eingansbereich (2) und $g_m$ die Stromverstärkung der Stromquelleneinrichtung bedeuten.

**8.** Schaltungsanordnung nach einem der vorangehenden Ansprüche 3 bis 7,
**dadurch gekennzeichnet,**
**daß** die Steuereinrichtung (6) eine Vergleichseinrichtung (8) aufweist, welche zum Vergleichen einer zugeführten Regelgröße mit einer vorgegebenen Führungsgröße und zum Generieren und Bereitstellen eines Vergleichssignals und/oder Steuersignals, insbesondere an die Kompensationseinrichtung (5), ausgebildet ist.

**9.** Schaltungsanordnung nach einem der vorangehenden Ansprüche,
**dadurch gekennzeichnet,**

- **daß** die Kompensationseinrichtung (5) eine Mehrzahl Stromquelleneinrichtungen (7) aufweist,
- **daß** die Steuereinrichtung (6) eine Registereinrichtung (9) aufweist und
- **daß** die Registereinrichtung (9) zum Auswählen und/oder Bestimmen der aktiven und/oder der zu aktivierenden Stromquelleneinrichtungen (7) und/oder der jeweiligen Stromverstärkungen ausgebildet ist.

**10.** Schaltungsanordnung nach einem der vorangehenden Ansprüche 3 bis 9,
**dadurch gekennzeichnet,**
**daß** die Vergleichseinrichtung (8), die Steuereinrichtung (6) und/oder die Registereinrichtung (9), insbesondere extern, programmierbar ausgebildet sind.

Fig. 1

EP 1 152 425 A2

Fig. 2

EP 1 152 425 A2

Fig. 3

Fig. 4

EP 1 152 425 A2